# EUROPÄISCHE PATENTANMELDUNG

(11) **EP 1 670 136 A1**
(43) Veröffentlichungstag der Anmeldung: **14.06.2006**
(21) Anmeldenummer: 05025355.8
(22) Anmeldetag: 21.11.2005
(51) Int. Cl.: H03B 5/12, H03L 7/099

(54) **Spannungsgesteuerte Oszillatorschaltung mit analoger und digitaler Ansteuerung**

(30) Priorität: 13.12.2004 DE 102004059987
(71) Anmelder: Infineon Technologies AG, 81669 München (DE)
(72) Erfinder: Li Puma, Giuseppe, 44791 Bochum (DE); Pham-Stäbner, Duyen, 40885 Ratingen (DE); Stäbner, Georg, 40885 Ratingen (DE)
(74) Vertreter: Patentanwälte Lambsdorff & Lange

(57) **Zusammenfassung**

Ein VCO-Schaltkreis (20) weist eine Spule (21) und parallel dazu eine konstante Kapazität (24) und einstellbare Kapazitätselemente (22, 23) auf. Ein erstes Kapazitätselement (22) wird durch einen oder mehrere Varaktoren gebildet, deren Kapazität durch eine analoge Einstellspannung (Vₜᵤₙₑ) einstellbar ist, während ein zweites Kapazitätselement (23) durch eine Anordnung einer Mehrzahl von Kondensatoren gebildet wird, welche durch ein digitales Bitwort VCWD[N:1] ansteuerbar sind. Eine digitale Kalibration des VCO (20) erfolgt dadurch, dass bestimmt wird, ob die aktuelle Einstellspannung innerhalb eines bestimmten Spannungsbereichs liegt, und falls dies nicht der Fall ist, das digitale Bitwort um einen Bitwert inkrementiert oder dekrementiert wird.

## Beschreibung

Die Erfindung betrifft einen spannungsgesteuerten Oszillator-Schaltkreis nach dem Oberbegriff des Patentanspruchs 1.

In einer großen Anzahl von elektronischen Schaltkreisen werden heutzutage spannungsgesteuerte Oszillatoren (VCO, Voltage Controlled Oscillator) eingesetzt. Ein besonders wichtiges Anwendungsgebiet ist die Mobilkommunikation, in welcher ein spannungsgesteuerter Oszillator innerhalb einer phasenverriegelten Schleifenschaltung eingesetzt wird, um eine Ausgangsfrequenz mit hoher Stabilität und Genauigkeit zu erzeugen.

Die wichtigste Chip-Technologie für System-on-chip-(SoC-) Anwendungen ist heutzutage die CMOS-Technologie. Mit der stetigen Verkleinerung der kritischen Dimensionen dieser Technologie geht auch eine Verkleinerung der Versorgungsspannungen einher. Analoge Schaltkreis-Technologien sind jedoch nicht kompatibel mit dieser bei digitalen Schaltungen durchgeführten Skalierung. Wenn die Versorgungsspannung mit den Schaltkreisdimensionen skaliert werden, so besteht die größte Beeinträchtigung auf einem VCO-Schaltkreis in einem reduzierten Durchstimmbereich. Somit kann nur ein geringerer Frequenzbereich überdeckt werden, wodurch aufgrund von Technologietoleranzen und Temperaturvariationen ein Problem für die Massenfertigung resultiert.

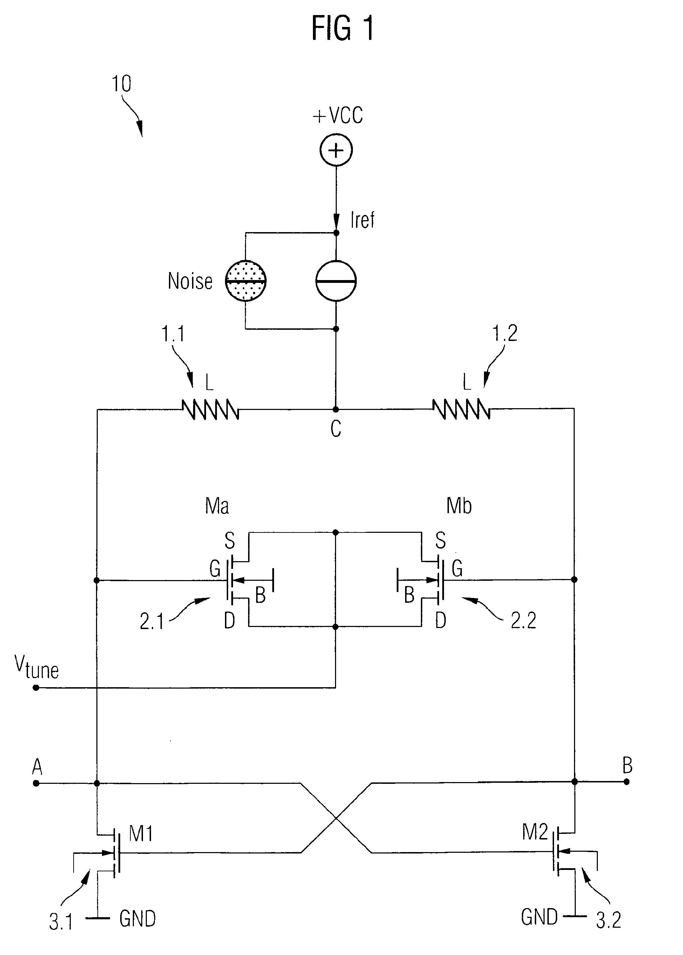

Die im Stand der Technik bekannten VCO-Konzepte verwenden typischerweise Varaktor-Dioden mit einem großen Durchstimmbereich, um den gewünschten Frequenzbereich überdecken zu können. In der Fig. 1 ist ein spannungsgesteuerter Oszillator-Schaltkreis 10 nach dem Stand der Technik schematisch dargestellt. In diesem LC-Schwingkreis sind in einem Schaltungszweig Spulenelemente 1.1 und 1.2 und in einem dazu parallel geschalteten Schaltungszweig Varaktoren 2.1 und 2.2 angeordnet. Die Varaktoren 2.1 und 2.2 stellen spannungsabhängige Kapazitätselemente dar, bei denen die Kapazität durch ein an ihren jeweiligen Source-Eingängen zugeführtes analoges Spannungssignal Vₜᵤₙₑ innerhalb eines bestimmten vorgegebenen Bereiches variabel eingestellt werden kann. Der Resonator wird somit aus den induktiven oder Spulenelementen 1.1 und 1.2 und den Varaktoren 2.1 und 2.2 gebildet. Die beiden Transistoren 3.1 und 3.2 mit den kreuzgekoppelten Gates gewährleisten durch eine Mitkopplung die nötige Ringverstärkung. An den Ausgängen A und B kann das Ausgangsspannungssignal des VCO-Oszillators entnommen werden.

Der Kapazitätsbereich der Varaktoren 2.1 und 2.2, welcher den Betriebsfrequenzbereich des VCO-Schaltkreises bestimmt, ist so auszulegen, dass Temperatureffekte und Prozesstoleranzen von vornherein mit berücksichtigt werden. Das beschriebene konventionelle VCO-Konzept weist jedoch aufgrund der Tatsache, dass in einer Submikron-CMOS-Technologie mit kritischen Dimensionen von beispielsweise 0,13 µm die Versorgungsspannung entsprechend skaliert, d.h. reduziert wird, bestimmte Nachteile auf. Ein Nachteil besteht darin, dass bei dieser VCO-Schaltkreistechnik der Durchstimmbereich aufgrund der geringeren Versorgungsspannung ebenfalls abnimmt. Da das Kapazitätsverhältnis Cₘₐₓ/Cₘᵢₙ der Varaktor-Dioden nahezu konstant bleibt, wird der Durchstimmbereich der Ausgangsfrequenz verringert, da die Versorgungsspannung verringert ist. Es sind somit geeignete Maßnahmen zu ergreifen, um unter Berücksichtigung von Produktionstoleranzen und Temperaturvariationen die volle Leistungsfähigkeit des VCO-Schaltkreises über den gesamten gewünschten Frequenzbereich zu gewährleisten.

Es ist somit Aufgabe der vorliegenden Erfindung, einen spannungsgesteuerten Oszillator-Schaltkreis anzugeben, welcher auch bei einer verringerten Versorgungsspannung einen ausreichend großen Durchstimmbereich der Ausgangsfrequenz aufweist.

Diese Aufgabe wird durch die kennzeichnenden Merkmale des Patentanspruchs 1 gelöst. Vorteilhafte Weiterbildungen und Ausgestaltungen sind Gegenstand von Unteransprüchen.

Der erfindungsgemäße spannungsgesteuerte Oszillator-Schaltkreis weist gattungsgemäß mindestens ein induktives Element und mindestens ein erstes kapazitives Element mit spannungsabhängiger Kapazität auf, welches durch eine analoge Einstellspannung ansteuerbar ist. Der spannungsgesteuerte Oszillator-Schaltkreis weist des Weiteren eine Anordnung von zweiten kapazitiven Elementen auf, welche durch Ansteuerung mittels eines digitalen Bitworts konfigurierbar ist.

Die Erfindung schafft somit eine Möglichkeit, den spannungsgesteuerten Oszillator-Schaltkreis durch Ansteuerung mittels des digitalen Bitworts abzustimmen.

Dabei kann in an sich bekannter Weise vorgesehen sein, dass eine Mehrzahl von ersten kapazitiven Elementen mit spannungsabhängiger Kapazität vorgesehen ist. Diese können durch Varaktoren oder Varaktor-Dioden gegeben sein.

Die Anordnung der zweiten kapazitiven Elemente kann in einer Mehrzahl von parallel geschalteten kapazitiven Elementen, wie Kondensatoren, gegeben sein. Diese Anordnung kann ihrerseits zu dem induktiven Element und dem ersten kapazitiven Element parallel geschaltet sein. Die zweiten kapazitiven Elemente können gleich große Kapazitätswerte aufweisen. Die Anordnung kann derart durch das digitale Bitwort ansteuerbar sein, dass je nachdem, ob eine Bitstelle auf 0 oder 1 gesetzt wird, eine mit dieser Bitstelle angesprochene Kapazität durch einen Schalter zugeschaltet oder abgetrennt wird.

In einer bevorzugten Ausführungsform des spannungsgesteuerten Oszillator-Schaltkreises enthält dieser zusätzlich eine Regeleinrichtung, welche feststellt, ob die aktuelle, den Varaktoren zugeführte analoge Einstellspannung innerhalb eines vorgegebenen Spannungsbereichs liegt. Abhängig von dem Ergebnis wird durch die Regeleinrichtung das der Anordnung aus zweiten kapazitiven Elementen zugeführte digitale Bitwort entweder auf dem aktuellen Wert belassen oder um ein Bit erhöht oder erniedrigt. Zu diesem Zweck kann die Regeleinrichtung einen Komparator enthalten, welchem an einem ersten Eingang die aktuelle Einstellspannung und an einem zweiten Eingang der obere oder der untere Grenzwert des vorgegebenen Spannungsbereichs zugeführt wird.

Der spannungsgesteuerte Oszillator-Schaltkreis ist im Normalfall Teil einer phasenverriegelten Regelschleife. Die digitale Kontrolle des VCO kann in verschiedenen Situationen oder zu verschiedenen Zeitpunkten des Betriebs der phasenverriegelten Regelschleife oder der Sende-/Empfangsschaltung durchgeführt werden. Es kann vorgesehen sein, dass der gesamte einstellbare Frequenzbereich in eine Anzahl von Gruppen unterteilt wird, von denen jede eine bestimmte Anzahl von Sende- oder Empfangskanälen umfasst. Die digitale Regelung kann dann vor Aufnahme des Sende- oder Empfangsbetriebs zunächst für jeden Kanal jeder Gruppe durchgeführt werden. Bei jeder Durchführung der digitalen Regelung wird zuerst die Einschwingzeit der phasenverriegelten Regelschleife mit den vorhandenen Einstellungen des VCO abgewartet und dann wird das korrigierte digitale Bitwort ermittelt und abgespeichert. Wenn dann später die Sende-/Empfangsvorrichtung in den aktiven Sende- oder Empfangsmodus wechselt, wird jeweils beim Anwählen eines bestimmten Frequenzkanals das jeweilige abgespeicherte digitale Bitwort aus dem Register aufgerufen und dem VCO zugeführt.

Im Folgenden wird die Erfindung anhand von Ausführungsbeispielen in Verbindung mit den Zeichnungsfiguren näher erläutert. Es zeigen:
- Fig. 1: einen konventionellen spannungsgesteuerten LC-Schaltkreis;

- Fig. 2: ein Ausführungsbeispiel für einen erfindungsgemäßen spannungsgesteuerten LC-Schaltkreis mit einem digitalen Kapazitätsfeld und einem analog gesteuerten Varaktor;
- Fig. 3: ein Ausführungsbeispiel für die Erzeugung der Referenzspannungen und die Eingabe einer der Referenzspannungen und der Einstellspannung in einen Komparator; und
- Fig. 4: ein Ausführungsbeispiel für ein Flussdiagramm zur Darstellung des Ablaufs der digitalen Regelung.

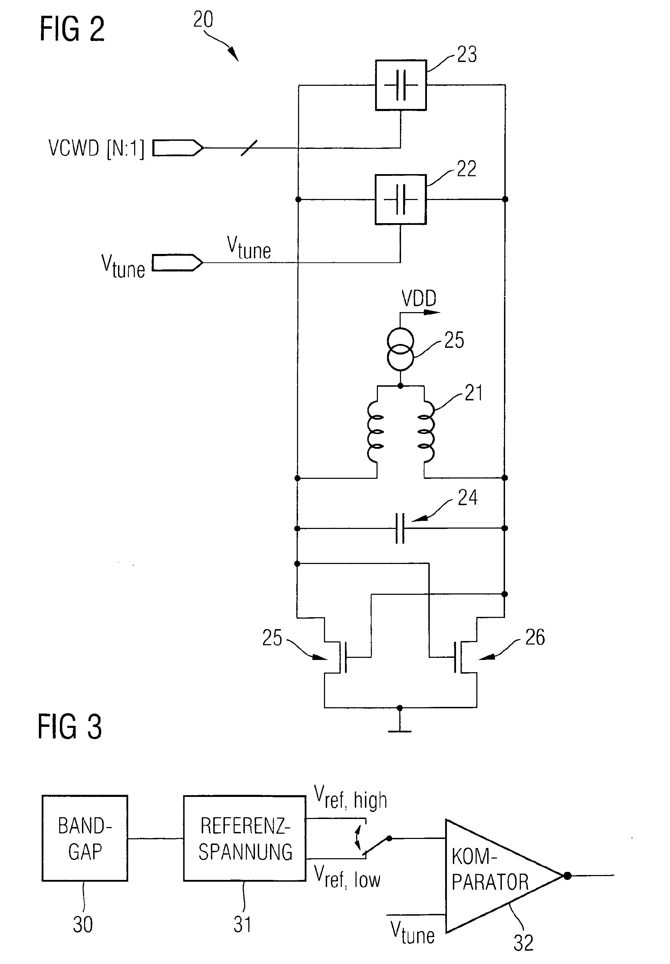

In der Fig. 2 ist ein Ausführungsbeispiel für einen erfindungsgemäßen spannungsgesteuerten Oszillator-Schaltkreis (VCO) 20 dargestellt. Eine Stromquelle 25 ist an ihrem Eingang mit der Versorgungsspannung VDD und an ihrem Ausgang mit einer Spule 21 verbunden. Die Spule 21 ist zu einem Kondensator 24 mit konstanter Kapazität sowie zu ansteuerbaren Kapazitätselementen 22 und 23 mit jeweils variablen Kapazitäten parallel geschaltet. Durch die Spule 21 und die Kapazitätselemente 22 bis 24 wird der LC-Schwingkreis gebildet. Die zu diesen Schaltungselementen parallel geschalteten Transistoren 25 und 26 mit den kreuzgekoppelten Gates gewährleisten durch eine Mitkopplung die nötige Ringverstärkung.

Das von der analogen Einstellspannung Vₜᵤₙₑ angesteuerte Kapazitätselement 22 kann einen oder mehrere Varaktoren, d.h. also Kondensatoren mit spannungsabhängiger Kapazität, enthalten. Das Kapazitätselement 23 ist eine Anordnung oder ein Feld von Kondensatoren, die durch ein digitales Bitwort VCWD[N:1] angesteuert werden. Die darin enthaltenen Kondensatoren weisen beispielsweise einen einheitlichen vorgegebenen Kapazitätswert auf und können bitweise einzeln angesteuert werden. Durch Erhöhung des digitalen Bitworts um ein Bit kann beispielsweise eine Kapazität zugeschaltet werden, während durch Erniedrigung des digitalen Bitworts um ein Bit eine Kapazität abgetrennt wird.

Aufgrund des begrenzten Durchstimmbereichs der Einstellspannung ist eine Kontrolle und Justage des VCO-Schaltkreises hinsichtlich der Mittenfrequenz durchzuführen, bevor in den aktiven Sende- oder Empfangsmodus geschaltet wird. Es kann aber auch vorgesehen sein, eine laufende Kontrolle und Justage des VCO während eines Betriebsmodus vorzusehen. Der von dem VCO abzudeckende Frequenzbereich wird in eine Anzahl von Gruppen unterteilt, von denen jede beispielsweise acht Frequenzkanäle umfasst.

Die digitale Einstellung oder Kalibration des VCO basiert auf der Idee, dass die Einstellspannung von jeder der innerhalb eines Frequenzbereichs einzustellenden Frequenzen innerhalb eines definierten Spannungsbereichs liegen muss. Dies bedeutet, dass ein Komparator verwendet werden kann, um die aktuell verwendete Einstellspannung mit dem oberen oder dem unteren Grenzwert des definierten Frequenzbereichs zu vergleichen. Abhängig von dem Ergebnis des Vergleichs wird das digitale Bitwort VCWD[N:1] um ein Bit erhöht oder erniedrigt.

In der Fig. 3 ist ein Blockschaltbild für die Erzeugung der zwei Referenzspannungen und den Vergleich mit der Einstellspannung dargestellt. Mit dieser Schaltung wird überprüft, ob die aktuelle Einstellspannung innerhalb des vorgegebenen Spannungsfensters liegt. Hierzu werden aus einer Bandgap-Schaltung 30 und einer nachgeschalteten Referenzspannungsschaltung 31 zwei Referenzspannungen V_{ref,low} (untere Fenstergrenze) und V_{ref,high} (obere Fenstergrenze) erzeugt. Diese aus der Referenzspannungsschaltung 31 abgeleiteten Referenzspannungen sind zumeist für einen bestimmten VCO typische Frequenzwerte. Einer der beiden Referenzspannungen wird je nach Stellung eines Schalters in einen ersten Eingang eines Komparators 32 eingegeben, während die aktuelle Einstellspannung Vₜᵤₙₑ in den zweiten Eingang des Komparators 32 eingegeben wird. Die Regelung erfolgt derart, dass die phasenverriegelte Schleife (PLL), von der der VCO ein Teil ist, einschwingt und nachdem die Einschwing- oder Einstellzeit der PLL abgelaufen ist, die Einstell- oder Tuning-Spannung nacheinander mit den Referenzspannungswerten V_{ref,low} und V_{ref,high} verglichen wird. Liegt die Tuning-Spannung innerhalb des Spannungsfensters, ist die Regelung fertig und der VCO ist justiert. Liegt die Tuning-Spannung oberhalb V_{ref,high} oder unterhalb von V_{ref,low}, so wird das Kapazitätsfeld 23 durch das digitale Bitwort um einen Kapazitätswert inkrementiert oder dekrementiert.

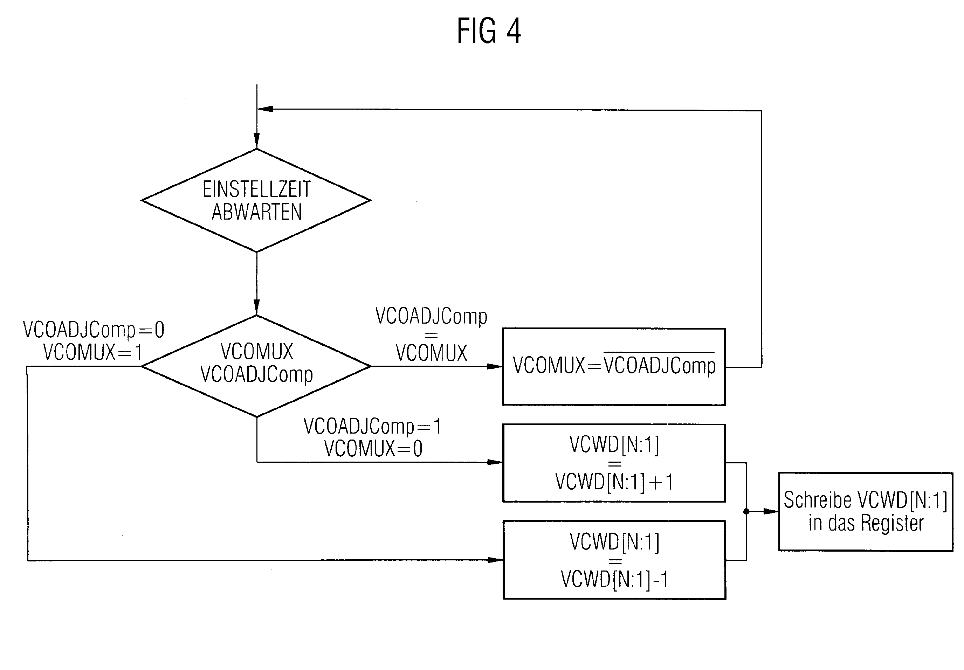

In der Fig. 4 ist ein schematisches Flussdiagramm des Ablaufs der Regelung dargestellt. Wenn darin der Wert VCOMUX = 1 ist, so wird ein Vergleich der Tuning-Spannung mit dem oberen Referenzspannungswert vorgenommen und wenn der Wert VCOMUX = 0 ist, so wird ein Vergleich der Tuning-Spannung mit dem unteren Referenzspannungswert vorgenommen. Der Wert VCOADJComp stellt den Ausgangswert des Komparators dar. Der Einstellalgorithmus wird wie folgt abgearbeitet:
1. Die Einschwing- oder Einstellzeit der PLL wird gesetzt.
2. Die Referenzspannung wird auf den unteren bzw. den oberen Referenzspannungswert eingestellt (durch Schalterstellung in Fig. 3).
3. Die gewünschte mittlere Frequenz MidFreq und die entsprechende Gruppennummer GroupNo werden ausgewählt.
4. Die Kalibration beginnt: Ein interner Zähler wird entsprechend der Einschwingzeit gesetzt.
5. Wenn der Zähler den Wert "0" erreicht, signalisiert dies, dass die PLL eingeschwungen ist und der Komparatorausgang durch den Digitalteil gelesen wird. Abhängig von dem verglichenen Spannungswert (siehe Schritt 2.) wird VCWD[N:1] um einen Bitwert erhöht oder erniedrigt. Der Zähler wird erneut mit der Einschwingzeit geladen. Sobald der Komparatorausgang andeutet, dass ein Grenzwert überschritten bzw. unterschritten wurde, wird die Referenzspannung auf den anderen Grenzwert gewechselt.
6. Der letzte Schritt wird wiederholt, bis die gewünschte Tuning-Spannung innerhalb des Spannungsfensters liegt.
7. Der letzte Wert von VCWD[N:1] wird in dem zugeordneten Register gespeichert.

Die oben beschriebene Sequenz wird für jeden Kanal in jeder Gruppe ausgeführt. Im aktiven Betriebsmodus wird bei jedem gewünschten Kanal der korrekte Wert des digitalen Bitworts VCWD[N:1] an den VCO angelegt, bevor die PLL aktiviert wird.

## Patentansprüche

1. Spannungsgesteuerter Oszillator-Schaltkreis (20), mit
- mindestens einem induktiven Element (21),
- mindestens einem ersten kapazitiven Element (22) mit spannungsabhängiger Kapazität, welches durch eine analoge Einstellspannung (Vₜᵤₙₑ) ansteuerbar ist,
**gekennzeichnet durch**
- eine Anordnung von zweiten kapazitiven Elementen (23), welche **durch** Ansteuerung mittels eines digitalen Bitworts (VCWD[N:1]) konfigurierbar ist.

2. Spannungsgesteuerter Oszillator-Schaltkreis nach Anspruch 1,
**dadurch gekennzeichnet, dass**
- eine Mehrzahl von ersten kapazitiven Elementen (22) mit spannungsabhängiger Kapazität vorgesehen ist.

3. Spannungsgesteuerter Oszillator-Schaltkreis nach Anspruch 1 oder 2,
**dadurch gekennzeichnet, dass**
- das kapazitive Element (22) durch einen Varaktor gegeben ist.

4. Spannungsgesteuerter Oszillator-Schaltkreis nach einem der vorhergehenden Ansprüche,
**gekennzeichnet** d u r c h
- eine Regeleinrichtung (30-32), welche feststellt, ob die aktuelle analoge Einstellspannung innerhalb eines vorgegebenen Spannungsbereichs liegt und abhängig von dem Ergebnis das digitale Bitwort auf dem aktuellen Wert belässt oder um einen Bitwert erhöht oder erniedrigt.

5. Spannungsgesteuerter Oszillator-Schaltkreis nach Anspruch 4,
**dadurch gekennzeichnet, dass**
- die Regeleinrichtung (30-32) einen Komparator (32) enthält, welchem an einem ersten Eingang die aktuelle Einstellspannung und an einem zweiten Eingang der obere oder der untere Grenzwert des vorgegebenen Spannungsbereichs zugeführt wird.

6. Phasenverriegelte Regelschleife (PLL) mit einem spannungsgesteuerten Oszillator-Schaltkreis nach einem der vorhergehenden Ansprüche.
